**Europäisches Patentamt**

**European Patent Office**

**Office européen des brevets**

(11) Veröffentlichungsnummer: **0 024 355**
**B1**

(12) # EUROPÄISCHE PATENTSCHRIFT

(45) Veröffentlichungstag der Patentschrift:
20.03.85

(21) Anmeldenummer: 80104911.5

(22) Anmeldetag: 18.08.80

(51) Int. Cl.⁴: **C 23 C 14/00, B 23 K 35/00**

(54) **Verfahren zum Befestigen von in Scheiben- oder Plattenform vorliegenden Targetmaterialien auf Kühlteller für Aufstäubanlagen.**

(30) Priorität: 21.08.79 DE 2933835

(43) Veröffentlichungstag der Anmeldung:
04.03.81 Patentblatt 81/9

(45) Bekanntmachung des Hinweises auf die Patenterteilung:
20.03.85 Patentblatt 85/12

(84) Benannte Vertragsstaaten:
CH FR GB IT LI SE

(56) Entgegenhaltungen:
CH - A - 436 852
GB - A - 624 369
GB - A - 698 173
GB - A - 1 051 393
US - A - 3 940 051

THE REVIEW OF SCIENTIFIC INSTRUMENTS, Band 44,
Nr. 4, April 1973, New York, US, C. TERHUNE: "Target
bonding (for sputtering)", Seiten 522-523
JOURNAL OF PHYSICS E. SCIENTIFIC INSTRUMENTS;
Band 5, Nr. 5, Mai 1972, London, GB A. ZOZIME et al.:
"Achievement of isolated and cooled targets for a
cathodic sputtering device" Seiten 417-419
SOLID STATE TECHNOLOGY, Band 12, Nr. 12,
Dezember 1969, Washington, US "A bonding process of
sputtering target materials", Seiten 29, 68

(73) Patentinhaber: **Siemens Aktiengesellschaft, Berlin und München Wittelsbacherplatz 2, D-8000 München 2 (DE)**

(72) Erfinder: **Lauterbach, Richard, Berchemstrasse 13, D-8000 München 21 (DE)**
Erfinder: **Keller, Hartmut, Dipl.-Ing., Feichtetstrasse 2, D-8134 Pöcking (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Beschreibung

Die Erfindung bezieht sich auf ein Verfahren zum Befestigen von in Scheiben- oder Plattenform vorliegenden Targetmaterialien auf Kühlteller für Aufstäubanlagen.

In Aufstäubanlagen (Sputter-Anlagen) ist das zu verstäubende Material auf wassergekühlten Tellern als Scheibe oder Platte aufgebracht. Die Wasserkühlung soll die Aufheizung des Targetmaterials in der Aufstäubanlage durch die bei der Plasmaentladung auftreffenden Elektronen verhindern. Zur Erzielung eines guten Kühleffektes ist der Kühlteller meistens aus Kupfer gefertigt. Eine gute Kühlung ist aber nur dann gewährleistet, wenn zwischen Targetmaterial und Kühlteller ein guter Wärmekontakt besteht.

Es sind Targets bekannt, bei denen das Targetmaterial mit Hilfe von Weichlotfolien auf dem Kühlteller «gebondet» ist. Weichlotfolien weisen bei den meist unlötbaren Targetmaterialien nur eine geringe mechanische Haftfähigkeit auf, so dass sich die Targetmaterialien im Betrieb häufig teilweise oder vollständig ablösen.

Aus «The Review of Scientific Instruments», Band 44, Nr. 4, April 1973, Seiten 522 bis 523 ist ein Verfahren zum Befestigen von Targets auf Kühlteller für Aufstäubanlagen bekannt, bei welchem die Targets durch Aufspritzen oder Aufdampfen erst mit einer maximal 0,5 µm dicken Chromschicht dann mit einer maximal 0,8 µm dicken Kupferschicht und danach mit einer maximal 0,4 µm dicken Goldschicht beschichtet und dann durch Weichlöten mit dem Kühlteller verbunden werden. Die Chromschicht soll hierbei als Diffusionssperre dienen und eine Kontamination des Targetmaterials mit dem verwendeten Lot verhindern.

Aus der US-A-3 940 051 ist es bekannt, zur Verbindung eines Ferritkörpers mit einer metallischen Wand den Ferritkörper durch Aufstäuben erst mit einer 1 µm dicken Nickel-Chrom-Schicht, dann mit einer 3 µm dicken Kupferschicht und danach mit einer maximal 1 µm dicken Goldschicht zu beschichten und dann mit Hilfe eines Weichlotes mit der metallischen Wand zu verlöten. Die Goldschicht kann sich dabei vollständig in dem Weichlot auflösen.

Der Erfindung liegt die Aufgabe zugrunde, ein Verfahren zum Befestigen von in Scheiben- oder Plattenform vorliegenden Targetmaterialien auf Kühlteller für Aufstäubanlagen zu schaffen, mit dem praktisch sämtliche gebräuchlichen Targetmaterialien haftfest und mit gutem Wärmekontakt mit den Kühltellern verbunden werden können.

Diese Aufgabe wird erfindungsgemäss dadurch gelöst, dass die Targetscheiben oder -platten mit einer dem Targetmaterial angepassten Haftschicht und anschliessend mittels Plasmaspritzen mit einer ca. 30 bis 100 µm dicken lötbaren Deckschicht aus Kupfer, Kupfer-Glas-Mischungen oder Silber versehen werden, dass die auf diese Weise beschichteten Targetscheiben oder -platten und die Kühlteller getrennt voneinander vorbelotet und anschliessend ohne Verwendung eines Flussmittels durch Weichlöten miteinander verbunden werden.

Die mit dem erfindungsgemässen Verfahren hergestellten Verbindungen gewährleisten nicht nur eine gute Haftung, sondern auch einen guten Wärmekontakt. Insbesondere wird durch die relativ grosse Schichtdicke der durch Plasmaspritzen aufgebrachten lötbaren Deckschicht aus Kupfer, Kupfer-Glas-Mischungen oder Silber sichergestellt, dass die Deckschicht nicht durch Diffusion ins Weichlot aufgelöst werden kann. Damit ist dann auch eine thermische Überlastung der Targets beim Betrieb bis nahe an den Schmelzpunkt des Lots auch über einen langen Zeitraum möglich, ohne dass sich die Lötverbindung ganz oder teilweise löst.

Vorteilhafte Ausgestaltungen des erfindungsgemässen Verfahrens gehen aus den Unteransprüchen hervor.

Ausführungsbeispiele der Erfindung werden im folgenden anhand der Zeichnung näher beschrieben.

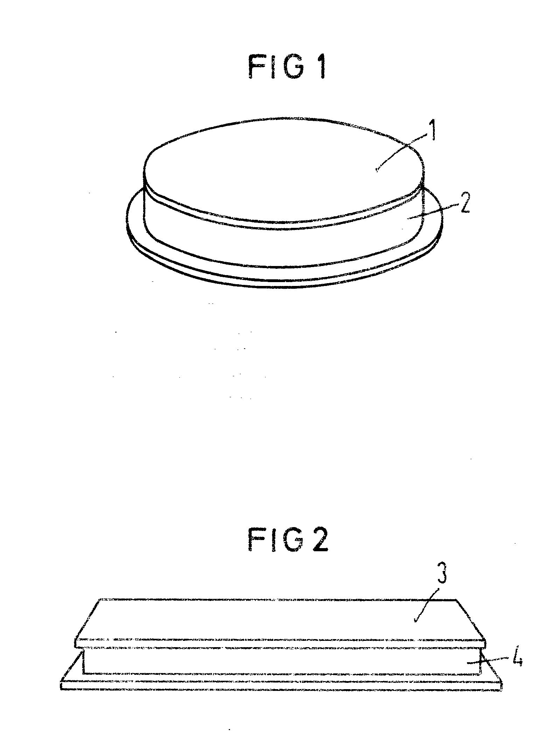

In der Zeichnung sind zwei nach dem erfindungsgemässen Verfahren gelötete Targets dargestellt, wobei in Figur 1 das Target eine Scheibenform und in Figur 2 eine Plattenform aufweist.

Mit 1 ist eine Targetscheibe aus beliebigem Material bezeichnet, die auf einem Kühlteller 2 durch Löten befestigt ist. Figur 2 zeigt eine Targetplatte 3, die auf einem rechteckförmigen Kühlteller 4 aufgelötet ist.

Die Fertigung des in Figur 1 dargestellten Targets geht nun in folgender Weise so vor sich, dass auf die Targetscheibe 1 durch Plasmaspritzen eine Haftschicht aufgebracht wird, die dem Targetmaterial entsprechend angepasst ist. Anschliessend wird auf diese Haftschicht ebenfalls durch Plasmaspritzen eine Kupfer, Kupfer-Glas oder Silberschicht aufgebracht, um die Targetscheibe 1 lötfähig zu machen. Vor dem Aufbringen der Plasmaspritzschichten wird bei Verwendung eines metallischen Targetmaterials die Scheibe an der Verbindungsstelle sandgestrahlt und entsprechend gereinigt. Nach dem Aufbringen der Haftschicht und der lötbaren Schicht werden die Targetscheibe 1 sowie der Kühlteller 2 unter Verwendung geeigneter Weichlötflussmittel vorbelotet. Danach werden die Targetscheibe und der Kühlteller gereinigt und damit die Flussmittelrückstände entfernt. Danach wird durch Reflow-Löten die Targetscheibe 1 mit dem Kühlteller 2 ohne Verwendung eines Flussmittels verlötet.

Bei nichtlötbaren metallischen Targetmaterialien wie z.B. Aluminium, Aluminium-Silizium, Aluminium-Tantal, Tantal, Chrom, Molybdän hat sich als Haftschicht Nickel, Nickel-Chrom-Legierungen, Nickel-Aluminiummischungen (vorzugsweise 80/20%), Ni-Al-Mo-Mischungen, Aluminium-Bronze, Molybdän, Wolfram, Aluminium, Aluminium-Silizium-Legierungen, Zink, Kupfer und Kupfer-Glas-Mischungen vorzüglich bewährt. Die Haftschicht dient hierbei gleichzeitig auch als Diffusionssperre.

Mit dem erfindungsgemässen Verfahren können aber auch direkt lötfähige Targetmaterialien befestigt werden, wie beispielsweise Gold, Silber, Paladium, Platin und Hartlote, die eine starke Löslichkeit für Weichlote aufweisen und daher während des Lötvorgangs mit dem Weichlot legieren und ihre Zusammensetzung ändern. Die plasmagespritze Haftschicht bzw. eine weitere Zwischenschicht erfüllt bei diesen Werkstoffen nicht nur die Aufgabe der besonders guten Bindung, sondern wirkt darüber hinaus gleichzeitig als Diffusionssperre, welche ein Legieren des Targetmaterials mit dem Weichlot verhindert. Als Haftschicht werden vorzugsweise Nickel, Nickel-Chrom-Legierungen, Nickel-Aluminium-Mischungen (vorzugsweise 80/20%), Nickel-Aluminium-Molybdän-Mischungen, Aluminium-Bronze, Molybdän, Wolfram, Aluminium, Aluminium-Silizium-Legierungen, Zink, Kupfer und Kupfer-Glas-Mischungen verwendet, das gleichzeitig als Diffusionssperre für Weichlot dient, bzw. wird als Diffusionssperre einer dieser Werkstoffe als Zwischenschicht auf eine geeignete Haftschicht aufgespritzt. Die lötfähige Deckschicht besteht in jedem Falle aus Kupfer, einer Kupfer-Glas-Mischung oder aus Silber mit einer Schichtdicke von ca. 30 bis 100 μm.

Werden Targetmaterialien aus Glas, Oxidkeramiken und Silizium verwendet, so wird als Haftschicht vorzugsweise Aluminium, Aluminium-Silizium-Legierungen, Kupfer, Kupfer-Glas-Mischungen, Zink, Wolfram, Aluminium-Bronze oder Molybdän verwendet. Die lötfähige Deckschicht besteht in jedem Falle aus Kupfer, Kupfer-Glas-Mischungen oder Silber mit einer Schichtdicke von ca. 30 bis 100 μm.

Bei Targetscheiben oder -platten aus Graphit wird als Haftschicht Wolfram verwendet. Auf diese Haftschicht wird dann als Diffusionssperre eine Zwischenschicht aus Nickel, Nickel-Aluminium-Mischungen, Nickel-Aluminium-Molybdän-Mischungen, Aluminium-Bronze, Aluminium oder Aluminium-Silizium-Legierungen aufgebracht. Anschliessend wird dann wieder mittels Plasmaspritzen eine ca. 30 bis 100 μm dicke lötbare Deckschicht aus Kupfer, Kupfer-Glas-Mischungen oder Silber aufgebracht.

## Patentansprüche

1. Verfahren zum Befestigen von in Scheiben- oder Plattenform vorliegenden Targetmaterialien auf Kühlteller für Aufstäubanlagen, dadurch gekennzeichnet, dass die Targetscheiben oder -platten (1, 3) mit einer dem Targetmaterial angepassten Haftschicht und anschliessend mittels Plasmaspritzen mit einer ca. 30 bis 100 μm dicken lötbaren Deckschicht aus Kupfer, Kupfer-Glas-Mischungen oder Silber versehen werden, dass die auf diese Weise beschichteten Targetscheiben oder -platten (1, 3) und die Kühlteller (2, 4) voneinander getrennt vorbelotet und anschliessend ohne Verwendung eines Flussmittels durch Weichlöten miteinander verbunden werden.

2. Verfahren nach Anspruch 1, dadurch gekennzeichnet, dass die Targetscheiben oder -platten (1, 3) und die Kühlteller (2, 4) mit Hilfe des Reflow-Lötens miteinander verbunden werden.

3. Verfahren nach Anspruch 1 oder 2, dadurch gekennzeichnet, dass die dem Targetmaterial angepasste Haftschicht ebenfalls durch Plasmaspritzen auf die Targetscheiben oder -platten (1, 3) aufgebracht wird.

4. Verfahren nach Anspruch 3, dadurch gekennzeichnet, dass nach dem Aufbringen der Haftschicht eine Zwischenschicht ebenfalls durch Plasmaspritzen aufgebracht wird.

5. Verfahren nach einem der Ansprüche 1 bis 4, dadurch gekennzeichnet, dass bei metallischen Targetscheiben oder -platten (1, 3) als Haftschicht oder als auf die Haftschicht aufgebrachte Zwischenschicht Nickel, Nickel-Chrom-Legierungen, Nickel-Aluminium-Mischungen, Nickel-Aluminium-Molybdän-Mischungen, Aluminium-Bronze, Molybdän, Wolfram, Aluminium, Aluminium-Silizium-Legierungen, Zink, Kupfer oder Kupfer-Glas-Mischungen verwendet werden.

6. Verfahren nach einem der Ansprüche 1 bis 4, dadurch gekennzeichnet, dass bei Targetscheiben oder -platten (1, 3) aus Glas, Oxidkeramik und Silizium als Haftschicht Aluminium, Aluminium-Silizium-Legierungen, Kupfer, Kupfer-Glas-Mischungen, Zink, Wolfram, Aluminium-Bronze oder Molybdän verwendet werden.

7. Verfahren nach einem der Ansprüche 1 bis 4, dadurch gekennzeichnet, dass bei Targetscheiben oder -platten (1, 3) aus Graphit als Haftschicht Wolfram verwendet wird und dass auf die Haftschicht als Diffusionssperre eine Zwischenschicht aus Nickel, Nickel-Aluminium-Mischungen, Nickel-Aluminium-Molybdän-Mischungen, Aluminium-Bronze, Aluminium oder Aluminium-Silizium-Legierungen aufgebracht wird.

## Claims

1. A process for fastening disc- or plate-shaped target materials to cooling plates for cathodic sputtering devices, characterised in that the target discs or target plates (1, 3) are provided with an adhesive layer, which is matched to the target material, and subsequently, by plasma-spraying, with a solderable top layer to a thickness of 30 to 100 μm and which consists of copper, copper-glass-mixtures, or silver; that the target discs or target plates (1, 3) so coated, and the cooling plates (2, 4), are pre-soldered separately from one another and are subsequently connected to one another by soft soldering without the use of a flux.

2. A process as claimed in Claim 1, characterised in that the target discs or target plates (1, 3) and the cooling plates (2, 4) are connected to one another with the aid of reflow soldering.

3. A process as claimed in Claim 1 or 2, characterised in that the adhesive layer which is matched to the target material, is also applied to the target discs or plates (1, 3) by plasma-spraying.

4. A process as claimed in Claim 3, characterised in that, after the application of the adhesive layer, an intermediate layer is also applied by plasma-spraying.

5. A process as claimed in one of Claims 1 to 4, characterised in that with metallic target discs or plates (1, 3), nickel, nickel-chromium alloys, nickel-aluminium mixtures, nickel-aluminium-molybdenum mixtures, aluminium bronze, molybdenum, tungsten, aluminium, aluminium-silicon alloys, zinc, copper or copper-glass mixtures, are used as the adhesive layer or as an intermediate layer applied on the adhesive layer.

6. A process as claimed in one of Claims 1 to 4, characterised in that with target discs or plates (1, 3), made of glass, oxide ceramic and silicon, aluminium, aluminium-silicon alloys, copper, copper-glass mixtures, zinc, tungsten, aluminium bronze, or molybdenum, are used as the adhesive layer.

7. A process as claimed in one of Claims 1 to 4, characterised in that with target discs or plates (1, 3), made of graphite, tungsten is used as the adhesive layer; and that an intermediate layer made of nickel, nickel-aluminium mixtures, nickel-aluminium-molybdenum mixtures, aluminium bronze, aluminium, or aluminium-silicon alloys, is applied on the adhesive layer as a diffusion barrier.

**Revendications**

1. Procédé pour fixer des matériaux de cibles, présents sous la forme de disques ou de plaques, sur des plateaux de refroidissement pour des installations de pulvérisation, caractérisé par le fait qu'on applique sur les disques ou les plaques formant cible (1, 3) une couche adhésive adaptée au matériau de la cible et qu'on applique ensuite, au moyen d'une pulvérisation plasmatique, une couche de revêtement soudable possédant une épaisseur d'environ 30 à 100 µm et constituée par du cuivre, des mélanges de cuivre et de verre ou de l'argent, qu'on soude préalablement, séparément les uns des autres, les disques ou plaques formant cible (1, 3) ainsi recouverts et les plateaux de refroidissement (2, 4) et qu'on les relie ensuite entre eux par un brasage tendre sans l'utilisation de flux.

2. Procédé suivant la revendication 1, caractérisé par le fait qu'on relie entre eux les disques ou plaques formant cibles (1, 3) et les plateaux de refroidissement (2, 4) au moyen d'une soudure à reflux.

3. Procédé suivant la revendication 1 ou 2, caractérisé par le fait qu'on dépose également par pulvérisation plasmatique la couche adhésive adaptée au matériau de la cible sur les disques ou les plaques formant cible (1, 3).

4. Procédé suivant la revendication 3, caractérisé par le fait qu'après le dépôt de la couche adhésive, on dépose également par projection plasmatique une couche intermédiaire.

5. Procédé suivant l'une des revendications 1 à 4, caractérisé par le fait que dans le cas de disques ou de plaques métalliques formant cible (1, 3), on utilise pour former la couche adhésive ou la couche intermédiaire déposée sur cette couche adhésive, du nickel, des alliages de nickel et de chrome, des mélanges de nickel et d'aluminium, des mélanges de nickel, d'aluminium et de molybdène, du bronze d'aluminium, du molybdène, du tungstène, de l'aluminium, des alliages d'aluminium et de silicium, du zinc, du cuivre ou des mélanges de cuivre et de verre.

6. Procédé suivant l'une des revendications 1 à 4, caractérisé par le fait que dans le cas de disques ou de plaques formant cible (1, 3) constitués par du verre, une céramique à base d'oxyde et du silicium, on utilise pour former la couche adhésive, de l'aluminium, des alliages d'aluminium et de silicium, du cuivre, des mélanges de cuivre et de verre, du zinc, du tungstène, du bronze d'aluminium et du molybdène.

7. Procédé suivant l'une des revendications 1 à 4, caractérisé par le fait que dans le cas de disques ou de plaques formant cible (1, 3) en graphite, on utilise du tungstène pour constituer la couche adhésive et on dépose à titre d'éléments de blocage contre la diffusion, sur la couche adhésive, une couche intermédiaire formée de nickel, de mélanges de nickel et d'aluminium, de mélanges de nickel, d'aluminium et de molybdène, de bronze d'aluminium, d'aluminium ou d'alliages d'aluminium et de silicium.

## FIG 1

## FIG 2